# EUROPEAN PATENT APPLICATION

(11) **EP 1 464 407 A2**
(43) Date of publication of application: **06.10.2004**
(21) Application number: 04006343.0
(22) Date of filing: 17.03.2004
(51) Int. Cl.: B05B 9/03

(54) **Multi-mode film coating apparatus and method**

(30) Priority: 31.03.2003 US 459207 P; 14.10.2003 US 684739
(71) Applicant: NORDSON CORPORATION, Westlake, Ohio 44145-1119 (US)
(72) Inventor: Brewer, Gary J., Elyria, Ohio 44035 (US)
(74) Representative: Eisenführ, Speiser & Partner

(57) **Abstract**

A system and method for dispensing liquid coating patterns of varying width. The system uses a film coater (20), a liquid supply (22) coupled in fluid communication with the film coater (20) and configured to supply liquid to the film coater (20) under pressure, and a liquid pressure regulator (24) operatively connected to the coater (20). The liquid pressure regulator (24) selectively adjusts the pressure of the liquid supplied to the film coater (20) and is operated by pressurized air. A selector valve (26) is coupled to the liquid pressure regulator (24). First and second air pressure regulators (30,32) are coupled to the selector valve (26) and can selectively deliver air at first and second pressures to the selector valve (26). The selector valve (26) is moved between first and second positions for selectively delivering air under either the first pressure or the second pressure to the liquid pressure regulator (24) to thereby cause the liquid to be delivered to the film coater (26) at different pressures to change the width of the dispensed pattern.

## Description

### Field of the Invention

This invention generally relates to devices and methods for applying film coatings and, more specifically, to film coating apparatus having film width control capabilities.

### Background of the Invention

Packaged circuit boards for electronic instruments are typically coated by a moisture proof insulator film to protect the circuit boards from moisture, electrical leakage and dust. Preferably, the moisture proof insulator films are known as conformal coatings, formed from materials such as acrylic, polyurethane, or epoxy resinous materials. In the past, the width of the spray pattern on the circuit board was adjusted, for example, by varying the distance between the nozzle and the circuit board. Because the fan pattern width of the coating material changes as the distance from the nozzle changes, the pattern width on the circuit board or other substrate will correspondingly change if the nozzle is moved closer to or farther away from the substrate.

Various problems or challenges are presented by past methods of pattern width control using height or z-axis adjustment. For example, a thinner layer of coating material is applied to the circuit board or substrate when the width dimension of the spray pattern is greatest because the coating material is applied over a larger area. On the other hand, a proportionately thicker layer of coating material is applied by the spray nozzle when the width of the pattern is narrow because the same quantity or flow of coating material is discharged onto a smaller area. In many instances, it may be preferable to obtain a coating of uniform thickness across the entire circuit board or substrate. In other applications, it is desirable to dispense a bead of viscous material as opposed to a wide coating.

Typically, the application of beads has been accomplished by needle dispensers. Thus, film coaters have been used to coat wider areas on the circuit board, while a separate needle dispenser has been used to coat narrow regions of the circuit board. The use of needle dispensers and the z-axis adjustments made to film coaters have required accurate height position to control the dispense gap. This is needed for an accurate and precise deposition of beads. Most production situations for accurate dispensing require height sensing systems to control the distance between the coater or needle and the substrate. This is because of the tolerance variations of the needle. U.S. Patent No. 5,316,219 discloses one type of system which allows pattern width control without z-axis adjustment of the film coater. The system disclosed in that patent uses a pressure regulator to vary the pressure of the coating material supplied to the film coater and discusses the fact that lower coating material pressures will produce more narrow pattern widths, while higher coating material pressures will produce wider coating widths.

It would be desirable to provide dispensing apparatus which allows easy adjustment between at least two pattern widths, for example, which may be a wide pattern width and a narrow, bead-like pattern width.

### Summary of the Invention

The present invention generally provides a film coater system in which the spray pattern width may be changed during a coating sequence by selecting one of at least two preset air pressure regulators with a software controlled selector valve. The selector valve changes the air pressure input to, for example, a diaphragm controlled fluid pressure regulator. The fluid pressure regulator receives film coating material from a liquid supply and feeds that material at a selected pressure to a film coater.

Multiple fluid pressure requirements may be preset to correspond to a number of different pattern widths which may be selected during operation of the film coater. Because the air pressure regulators are preset and the control merely selects the position of a selector valve for directing the preset air pressure from one of the at least two air pressure regulators to the coating material pressure regulator, the system is easier to use than past systems. The system is also less complicated and more readily adapted to automated systems requiring on-the-fly changes in dispensed pattern widths. The major benefit stems from the use of a single dispenser with multiple modes of operation. This results in improved system throughput, a single valve/nozzle to maintain, and simpler set up and operation of the coating platform. In particular, the elimination of one dispenser eliminates the need for z-axis movement and height sensing, and also eliminates the need to move one dispenser out of the way while positioning another dispenser over the substrate.

These and other objects, advantages and features of the invention will be more readily apparent to those of ordinary skill in the art upon review of the following detailed description taken in conjunction with the accompanying drawings.

### Brief Description of the Drawings

Fig. 1 is a schematic elevational view of a film coating nozzle dispensing a wide pattern of coating material onto a substrate.
Fig. 2 is an elevational view similar to Fig. 1, but illustrating a second mode in which the nozzle dispenses a narrow, bead-like pattern of material onto the substrate.
Fig. 3 is a block diagram of a coating system configured in accordance with the preferred embodiment of the invention.

### Detailed Description of the Drawings

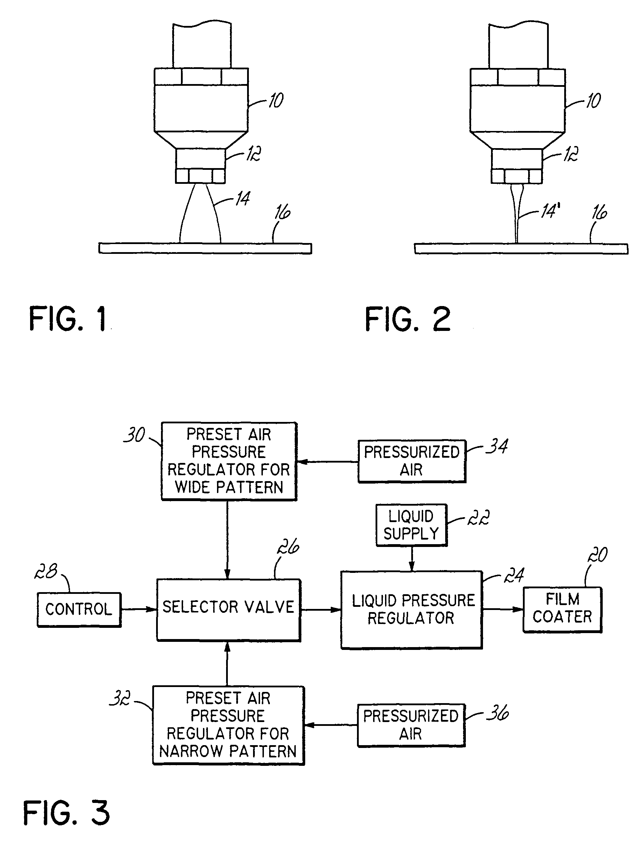

Referring first to Figs. 1 and 2, a film coater includes an adaptor 10 having a nozzle 12 configured to emit patterns of liquid 14, 14' having varying widths onto a substrate 16. For example, a film coater as described in U.S. Patent No. 5,316,219 or 5,336,320, each assigned to the assignee of the present invention, may be used with a 1/32" crosscut nozzle and a conformal coating liquid having a viscosity less than about 100 cps. It will be recognized that other types of nozzles may be used as well. Typically, to achieve wider coating widths (e.g., 1/2" wide), such as shown in Fig. 1, coating material pressures of between 10-30 PSI are used, while a pressure of less than 10 PSI may be used to achieve a narrow pattern width such as a bead-like pattern 14' (e.g., 1/32" wide) as shown in Fig. 2.

Fig. 3 illustrates a block diagram of a film coating system constructed in accordance with the invention. Specifically, a film coater 20 receives film coating material, such as a conformal coating material, from a liquid supply 22 which is pressurized. The pressure of the liquid is controlled by a fluid pressure regulator 24, such as one that is controllable by pneumatic pressure by use of a conventional diaphragm mechanism. Air pressure is supplied to the diaphragm controlled fluid pressure regulator 24 via a software controlled selector valve 26. The position of selector valve 26 is controlled by the operator via a control 28 such that, in one position or mode, pressurized air 34 is supplied through a preset air pressure regulator 30, while in a second position or mode pressurized air 36 is provided through a second preset air pressure regulator 32. Thus, when the first mode or position for selector valve 26 is chosen by the operator, the air pressure provided through regulator 30 causes fluid pressure regulator 24 to allow a higher liquid pressure to feed into film coater 20 therefore causing a wider coating pattern. On the other hand, when the second mode or position of selector valve 26 is chosen, the air pressure which is fed to fluid pressure regulator 24 via air pressure regulator 32 causes a lower pressure of liquid or coating material to feed into film coater 20 therefore causing a more narrow or even bead-like width of coating material to be dispensed onto the substrate such as shown in Fig. 2.

It will be appreciated that the system shown in Fig. 3 may be programmed using automated control logic, as would be readily understood by those of ordinary skill. As one example, the system may be programmed to automatically switch between more narrow patterns and wider patterns during different parts of a coating sequence on the same substrate or on different substrates. In switching between two or more coating pattern widths, the control need only move the selector valve to a different position thereby feeding preset air pressure through a corresponding air pressure regulator for producing the desired pattern width.

While the exemplary system has been illustrated and described herein as having multiple air pressure regulators for providing pressurized air at different pressures, it will be appreciated that the system may alternatively utilize an electronically controlled air pressure regulator that is adjustable in response to a signal from the control 28 to provide a range of desired air pressures to the liquid pressure regulator 24. Accordingly, only a single source of pressurized air would be required.

While the present invention has been illustrated by a description of a preferred embodiment and while this embodiment has been described in some detail, it is not the intention of the Applicants to restrict or in any way limit the scope of the appended claims to such detail. Additional advantages and modifications will readily appear to those skilled in the art. The various features of the invention may be used alone or in numerous combinations depending on the needs and preferences of the user. This has been a description of the present invention, along with the preferred methods of practicing the present invention as currently known. However, the invention itself should only be defined by the appended claims.

## Claims

1. A system for dispensing a liquid in coating patterns of selectively varying width, comprising:
a film coater for receiving the liquid and having dispensing nozzle for dispensing the liquid;
a liquid pressure regulator operatively connected to said film coater for selectively adjusting the pressure of the liquid supplied to said film coater, said liquid pressure regulator operated by pressurized air;
a selector valve coupled to said liquid pressure regulator;
a first air pressure regulator coupled to said selector valve and configured to deliver the pressurized air at a first pressure to said selector valve;
a second air pressure regulator coupled to said selector valve and configured to deliver the pressurized air at a second pressure to said selector valve; and
a control for moving said selector valve between first and second positions for selectively delivering the pressurized air under either said first pressure or said second pressure to said liquid pressure regulator to thereby cause the liquid to be delivered to said film coater at different pressures to change the width of the dispensed liquid coating pattern from said nozzle.

2. The system of claim 1, wherein said nozzle is a crosscut nozzle.

3. The system of claim 1, wherein said control comprises a user interface configured for selection, by an operator, of a first mode corresponding to said first position of said selector valve, and a second mode corresponding to said second position of said selector valve.

4. The system of claim 1, wherein said control is configured for automatic selection of a first mode corresponding to said first position of said selector valve, and a second mode corresponding to said second position of said selector valve.

5. The system of claim 1, wherein said first air pressure regulator is configured to provide the pressurized air to said selector valve at a pressure of approximately 10 psi to approximately 30 psi.

6. The system of claim 1, wherein said second air pressure regulator is configured to provide the pressurized air to said selector valve at a pressure less than approximately 10 psi.

7. The system of claim 1, wherein said first air pressure regulator is configured to provide the pressurized air to said selector valve at a pressure greater than said second air pressure regulator.

8. A method of dispensing a liquid onto a substrate in at least two different patterns having different widths, the method comprising:
supplying the liquid to a liquid pressure regulator operable by pressurized air to adjust the pressure of the liquid delivered to a film coater;
supplying pressurized air to a selector valve;
changing the position of the selector valve between at least two positions to select the air pressure delivered to the liquid pressure regulator; and
discharging the liquid from the film coater at a pressure determined by the liquid pressure regulator.

9. The method of claim 8, wherein changing the position of the selector valve comprises manually selecting one of the at least two positions of the selector valve.

10. The method of claim 8, wherein changing the position of the selector valve comprises automatically selecting one of the at least two positions of the selector valve using automated control logic.

11. The method of claim 8, wherein supplying pressurized air to the selector valve comprises:
supplying pressurized air at a first pressure of approximately 10 psi to approximately 30 psi; and
supplying pressurized air at a second pressure less than approximately 10 psi.

12. The method of claim 11, wherein the position of the selector valve is changed to select the first pressure to thereby dispense the liquid in a wide width pattern.

13. The method of claim 11, wherein the position of the selector valve is changed to select the second pressure to thereby dispense the liquid in a narrow width pattern.
